# EUROPÄISCHE PATENTANMELDUNG

(11) **EP 0 863 697 A2**
(43) Veröffentlichungstag der Anmeldung: **09.09.1998**
(21) Anmeldenummer: 98103470.5
(22) Anmeldetag: 27.02.1998
(51) Int. Cl.: H05K 9/00, G01N 21/89

(54) **Sensorgehäuse für einen gegenüber elektromagnetischer Strahlung empfindlichen optischen Sensor**

(30) Priorität: 05.03.1997 DE 19709012
(71) Anmelder: ELEKTRO-MECHANIK GMBH, D-57482 Wenden (DE)
(72) Erfinder: Harald, Wagner, 57223 Kreuztal (DE)
(74) Vertreter: Klingseisen, Franz, Dipl.-Ing.

(57) **Zusammenfassung**

Es wird ein Sensorgehäuse für einen gegenüber elektromagnetischer Strahlung empfindlichen optischen Sensor, insbesondere für eine Bahnlaufregeleinrichtung, vorgesehen, bei dem ein Lichtsender bzw. -empfänger (16) von einer Abschirmung aus leitendem Material umgeben ist, die aus einem im Querschnitt etwa U-förmigen Metallprofil (1) und einer in die Öffnung des Metallprofils eingesetzten lichtdurchlässigen Schicht (2) besteht, die zur leitenden Verbindung der Schenkelenden des Metallprofils (1) leitfähig ist oder mit einer leitfähigen Beschichtung (2a) versehen ist.

## Beschreibung

Die Erfindung betrifft ein Sensorgehäuse für einen gegenüber elektromagnetischer Strahlung empfindlichen optischen Sensor, bei dem der Lichtsender bzw. - empfänger von einer Abschirmung aus elektrisch leitendem Material umgeben ist, die als Farradayscher Käfig wirkt.

Der Erfindung liegt die Aufgabe zugrunde, eine solche Abschirmung kostengünstig so zu gestalten, daß sie vielfältig eingesetzt werden kann. Diese Aufgabe wird im wesentlichen durch ein im Querschnitt etwa

U-förmiges Metallprofil nach Anspruch 1 gelöst, wobei in der Öffnung des Profils eine Glasplatte eingesetzt ist, die zur leitenden Verbindung der Schenkelenden des Metallprofils mit einer leitfähigen Beschichtung versehen ist.

Eine beispielsweise Ausführungsform der Erfindung wird nachfolgend anhand der Zeichnung näher erläutert. Es zeigen
- Fig. 1: einen Querschnitt durch ein als Sensorgehäuse dienendes Metallprofil,
- Fig. 2: einen Querschnitt durch das Gehäuse mit eingesetztem Lichtsender und
- Fig. 3: einen Querschnitt durch das Gehäuse mit einem Sensorelement bzw. Lichtempfänger.

Mit 1 ist ein Metallprofil vorzugsweise aus Aluminium bezeichnet, das einen etwa U-förmigen Querschnitt hat. In die Öffnung des Profils 1 ist eine Glasplatte 2 eingesetzt, die auf der Innenseite mit einer elektrisch leitfähigen Beschichtung 2a versehen ist, welche an einer elektrisch leitfähigen Dichtschnur 3 anliegt, die in einer Längsnut 4 in einem Schenkel eines nach innen gezogenen Endabschnitts 5 des Profils 1 eingesetzt ist und über die gesamte Länge des Profils und der Glasscheibe eine elektrische Verbindung zwischen den gegenüberliegenden Schenkelenden des Profils herstellt.

Anstelle der mit einer elektrisch leitfähigen Beschichtung versehenen Glasplatte kann auch eine andere elektrische Verbindung zwischen den Endabschnitten des Profils dadurch vorgesehen werden, daß anstelle der Glasplatte eine elektrisch leitfähige und optisch durchlässige Schicht eingesetzt wird, beispielsweise ein elektrisch leitfähiges Gitter, eine mit einem elektrischen Leiter bedruckte transparente Platte oder dgl.

Die Glasplatte 2 ist vorzugsweise als Verbundglasscheibe ausgebildet, die aus leitfähiger Schicht, einer Glasschicht, einem Aufdruck und einer äußeren Glasschicht bestehen kann. Sie greift mit jeweils einem abgesetzten Rand in eine Längsnut 6 in dem nach hinten abgewinkelten Endabschnitt 5 der Schenkelenden ein. Damit die Glasplatte 2 mit der leitenden Beschichtung 2a an die elektrisch leitfähige Dichtschnur 3 fest angedrückt gehalten wird, ist zwischen Glasplatte und oberem Schenkel der Nut 6 ein Streifen 7 eingesetzt, der aus elastischem Material, bzw. Schaumstoff, bestehen kann. Auf diese Weise wird die Glasplatte 2 durch Klemmhalterung in dem Profil 1 gehalten, so daß es keiner Befestigungsschrauben oder dgl. bedarf. Hierfür kann es ausreichend sein, wenn die Dichtschnur 3 elastisch ist. Der Streifen 7 kann auch aus festem Kunststoff bestehen.

Die elektrisch leitfähige Dichtschnur 3, die ein beliebig geformtes Hohlkammerprofil oder auch ein von der Kreisform abweichendes Voll-Profil haben kann, hat vorzugsweise die Eigenschaft, daß bei zunehmender elastischer Verformung eine Erhöhung der elektrischen Leitfähigkeit auftritt. Dies kann durch in das Dichtungsmaterial eingelagerte leitfähige Partikel erreicht werden. Beim festen Andrücken der Glasplatte zum Profilinnenraum hin wird dadurch ein zunehmend kleiner werdender elektrischer Übergangswiderstand zwischen Glasplatte und Profil und somit eine günstigere Abschirmwirkung erreicht.

Zur Abdichtung zwischen Glasplatte 2 und Profil 1 ist eine Rundschnurdichtung 8 zwischen den Absatz der Glasplatte 2 und eine Abschrägung am Innenrand des oberen Schenkels der Nut 6 und/oder der Außenkante der Glasplatte eingesetzt. Diese Abschrägung bildet mit dem Klemmstreifen 7 eine im Querschnitt etwa V-förmige Nut.

Diese im Querschnitt etwa V-förmige Nut verhindert in Verbindung mit einer - z.B. im einfachsten Fall handelsüblichen - Rundschnurdichtung 8, daß sich die Rundschnurdichtung 8 auch bei unterschiedlicher Belastung, z.B. bei hängender Montage des Sensorgehäuses mit nach unten gerichteter Glasplatte, selbsttätig aus der Nut lösen kann. Insgesamt ergibt sich durch diesen Aufbau eine doppelte Abdichtung und damit ein hoher Schutz des Profilinnenraums.

Zur Klemmhalterung der Glasplatte 2 im Profil 1 kann zusätzlich die Rundschnurdichtung 8 verwendet werden, die ähnlich wie die leitfähige Dichtschnur 3 außer dem Querschnittsprofil einer im einfachsten Fall handelsüblichen Rundschnur, z.B. aus geschlossenzelligem Schaumstoff, auch eine Hohlprofilform aufweisen kann. Die Rundschnurdichtung 8 bewirkt eine seitliche Mittenzentrierung der Glasplatte. Die Glasplatte wird vorzugsweise ohne direkten Metallkontakt in dem Profil gehalten. Damit wird ein Verschleiß, z.B. bei Relativbewegungen durch unterschiedliche Wärmedehnung sowohl am Metall als auch an der Glasplatte und der aufgebrachten elektrisch leitfähigen Schicht 2a, vermieden. Durch die Klemmhalterung der Glasscheibe bzw. -platte 2 zwischen der elastischen Dichtschnur 3 und dem Klemmstreifen 7 sowie durch den Abstand der Glasscheibe vom Grund der Nut 6 hat die Glasscheibe keine direkte Berührung mit dem Metallprofil 1.

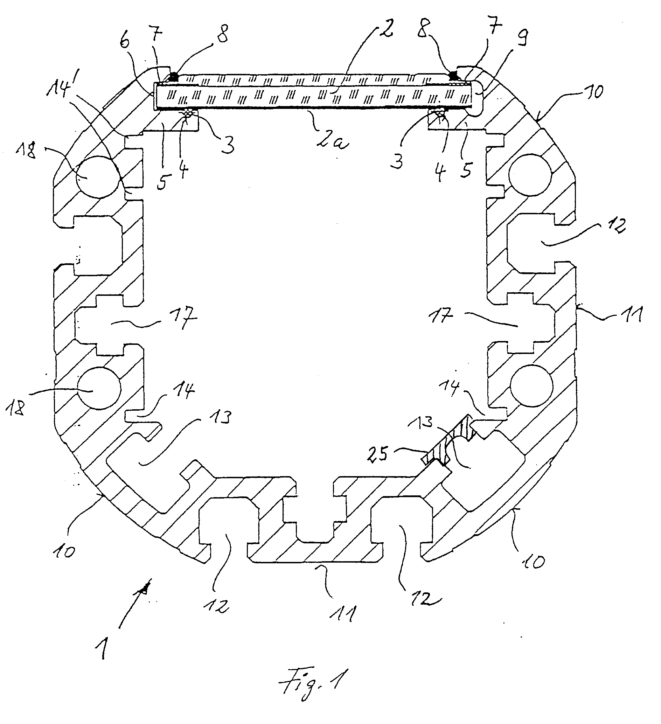

Bei 9 ist auf einer Seite des Profils 1 der Grund der Nut 6 vertieft ausgebildet, so daß sich ein Hohlraum ergibt. Der seitliche Hohlraum in der Nut 6 links in Fig. 1 und bei 9 reicht für eine seitlich unterschiedliche Längenausdehnung (in der Breite der Glasplatte) aus. Die Vertiefung der Nut bei 9 ist dazu vorgesehen, Montage und Demontage der gegenüber der lichten Weite der Profilöffnung breiteren Glasplatte 2 von oben zu ermöglichen, anstatt von der Stirnseite aus. Die Montage erfolgt dabei in der Weise, daß die Glasplatte 2 auf der Seite der linken Nut 6 angehoben bzw. schräg angestellt und danach in den Hohlraum 9 eingeschoben wird. Hierauf kann die linke Seite der Glasplatte 2 abgesenkt und an der Vorderkante des Endabschnitts 5 aufgelegt werden. Die Glasplatte kann dann in die linke Nut 6 eingeschoben werden. Durch Andrücken der Glasplatte 2 an den elastischen Dichtschnüren 3 bleibt ein ausreichender Spalt, um die Klemmstreifen 7 einschieben zu können. Danach werden die Rundschnurdichtungen 8 in die V-förmigen Nuten eingedrückt. Die Demontage erfolgt in umgekehrter Reihenfolge. Wie in Fig. 1 auf der rechten Seite wiedergegeben, ist der Hohlraum 9 am Boden der Nut 6 nach unten etwas verbreitert, so daß die Glasplatte 2 leichter schräg eingeführt werden kann.

Die Glasplatte 2 wird vorzugsweise kürzer ausgelegt als die Länge des Profils 1, so daß zwischen den Enden der Glasplatte und nicht dargestellten Abdeckplatten an den beiden Stirnseiten des Profils 1 eine elastische Abdichtung, bspw. ein Moosgummi, eingesetzt werden kann, damit auch in Längsrichtung des Profils 1 ein Spielraum zur Kompensation unterschiedlicher Wärmeausdehnung in Verbindung mit einer Abdichtung des Sensorgehäuses erreicht wird. Damit hat die Glasplatte 2 in alle sechs Richtungen ausreichendes Spiel, während eine zuverlässige Abdichtung bei Aufrechterhaltung der elektrischen Leitung erreicht wird.

Die elektrisch leitfähige Dichtschnur 3 kann auch in Schlauchform ausgebildet sein, damit sie stärker komprimierbar ist. Die Dichtschnur 3 kann beispielsweise aus einem Isoliermaterial bestehen, in dem in einem vorgegebenen Abstand Metallpartikel eingelagert sind. Durch Zusammenpressen des Materials der Dichtschnur 3 um bspw. etwa 20% wird ein zunehmender Kontakt der eingelagerten Metallpartikel hergestellt und damit die Leitfähigkeit der Dichtschnur erzielt.

Vorzugsweise besteht das Metallprofil 1 aus einem Aluminium-Strangpressprofil, das auf der Innen- und Außenseite aus Design- und Umweltgründen eloxiert ist, wobei die Eloxalschicht elektrisch isolierend wirkt. Um dennoch in einfacher Weise eine elektrische Leitung an den gegenüberliegenden Schenkelenden des Profils 1 zu erhalten, wird vor dem Eloxieren eine Abdeckung in Form einer Rundschnur, bspw. aus geschlossenzelligem Schaumstoff, in die Nut 4 eingelegt, die nach dem Eloxieren des Profils 1 wieder entfernt wird, so daß nach Einlegen der elektrisch leitfähigen Dichtschnur 3 über die Nut 4 eine elektrische Verbindung mit der leitenden Beschichtung 2a der Glasplatte hergestellt wird.

Gegebenenfalls kann vor dem Eloxieren bereits die endgültige elektrisch leitfähige Dichtschnur 3 eingelegt werden, die während des Eloxiervorgangs die Funktion des Abdeckens und anschließend nach Montage des Sensorgehäuses die Funktion der elektrischen Verbindung zwischen der elektrisch leitfähigen, aber optisch durchlässigen Abschirmebene und des metallenen Profilkörpers übernimmt.

Die Eloxalschicht auf dem Außenumfang des Profils 1 bildet eine gegen Umwelteinflüsse widerstandsfähige und optisch ansehnliche Oberfläche, die aber selbst bei einer Dicke im µ-Bereich elektrisch isolierend wirkt. Um trotz der Eloxalbeschichtung eine kostengünstige, langgestreckte elektrische Kontaktierung ohne mechanische Bearbeitung der teilweise mehr als ein Meter langen Profile 1 zu erreichen, wird die für die elektrische Kontaktierung vorgesehene Nut 4 vor und während des Eloxalvorgangs mit Dichtmaterial abgedeckt, so daß die für den Vorgang des elektrischen Oxidierens notwendige Flüssigkeit daran gehindert wird, in die Nut 4 einzudringen. Damit bleibt die Oberfläche der Nuten 4 leitfähig, und es kann ein elektrisch leitfähiges Material, wie Schnüre, Pasten, Kleber und dergleichen, in diese Nuten 4 eingebracht werden, um eine langgestreckte beidseitige Kontaktierung des auf der Außenseite mit einer Isolierschicht versehenen Profils zu erreichen.

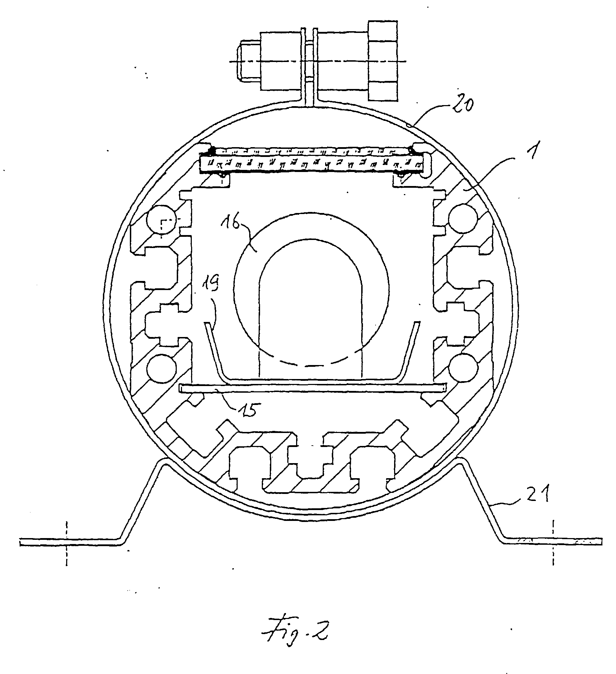

Der Außenumfang des Profils 1 besteht aus Teilkreisabschnitten 10 und dazwischen liegenden abgeflachten Abschnitten 11, die einer quadratischen oder rechteckigen Querschnittsform mit abgerundeten Ecken entsprechen. Durch die Teilkreisabschnitte 10 kann um das Profil 1 eine Befestigungsschelle 20 gelegt werden (Fig. 2), wie sie bei der Montage eines Rundquerschnitts verwendet wird. Auf den abgeflachten Abschnitten 11 des Außenumfangs sind Nuten 12 vorgesehen, damit das Profil 1 an geraden Flächen anderer Bauteile angeflanscht werden kann. Hierfür haben diese Nuten 12 eine etwa T-förmige Querschnittsform. Der Innenumfang des Profils 1 ist etwa quadratisch oder rech

teckig ausgebildet, wobei bei dem dargestellten Ausführungsbeispiel die unteren beiden Ecken abgeschrägt sind und in den abgeschrägten Flächen jeweils eine im Querschnitt T-förmige Nut 13 vorgesehen ist, die als Kabelkanal dient, wobei der Kabelkanal 13 mit einem Abdeckelement 25 verschlossen werden kann, wie Fig. 1 zeigt. Über diesen beiden innenliegenden Nuten 13 sind auf den gegenüberliegenden Seiten des Innenumfangs flache Nuten 14 zur Aufnahme einer Trägerplatte 15 für das Sensorelement 16 ausgebildet. Das Sensorelement 16 kann bspw. aus Fotodioden einer Leuchtstoffröhre oder einer Reihe von Leuchtdioden bestehen.

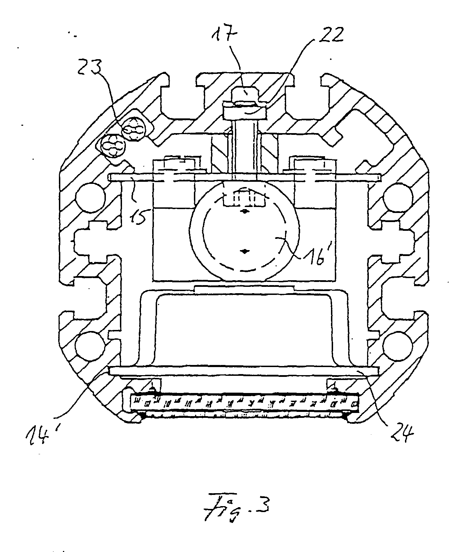

Entsprechend den Nuten 14 sind bei 14' flache Nuten am oberen Abschnitt des Innenumfangs ausgebildet, damit geeignete Halterungen bzw. Leiterplatten mit Elektronik z.B. zur Ansteuerung des Lichtsenders oder zur Auswertung des Lichtempfängers eingeschoben werden können. In diese Nuten 14' können auch optische Bauteile, wie Lichtraster, Linsensysteme und dergleichen, eingesetzt werden, wie dies auch Fig. 3 zeigt.

Bei 17 sind gegenüberliegende, im Querschnitt t-förmige Nuten ausgebildet, die zur Befestigung von zusätzlichen Bauteilen dienen können wie die Nut 17 in Fig. 3. Solche zusätzlichen Bauteile können beispielsweise Leistungshalbleiter oder auch Heizelemente sein. Im Falle eines Leistungshalbleiters, der beispielsweise die Leuchtstoffröhre 16 mit Energie versorgt und Wärme abgibt, wird eine thermisch gut leitende Verbindung mit dem Metallprofil 1 vorgesehen, damit über dieses die erzeugte Wärme nach außen abgeführt werden kann. Hierdurch können kleinere Baugrößen von Leistungshalbleitern bei gleicher Leistungsanforderung vorgesehen werden. Wenn andererseits in dem Metallprofil eine Heizung vorgesehen werden soll wegen des Einsatzes in einer kalten Umgebung, so kann durch das Metallprofil 1 eine gleichmäßige Wärmeverteilung innerhalb des Gehäuses des Sensors erreicht werden. In beiden Fällen dient das Metallprofil 1 als Wärmeleiter.

Die Nuten 17 auf dem Innenumfang, die nicht zur Befestigung von Sensorelementen und dgl. verwendet werden, ergeben eine sehr preisgünstige und wirkungsvolle Kühlung von beispielsweise Leistungshalbleiterlementen, die in dem Profil eingesetzt sind.

Mit 18 sind vier Längsbohrungen bezeichnet, die sich zur Verringerung der Wandstärke über die Länge des Profils 1 erstrecken. Von den Stirnseiten des Profils 1 aus können Innengewinde in den Bohrungen 18 vorgesehen werden, in die Halteschrauben für nicht dargestellte Abdeckplatten an den stirnseitigen Enden des Profils 1 eingeschraubt werden können. Es können auch Gewindeschäfte durch diese Bohrungen 18 geführt und die Abdeckplatten mittels Muttern befestigt werden.

Fig. 2 zeigt einen Querschnitt des Metallprofils mit darin eingesetztem Lichtsender in Form einer Leuchtstoffröhre 16, wobei mit 19 ein Teil des optischen Reflektors der Leuchtstofflampe bezeichnet ist. Das Metallprofil 1 wird von einer Schelle 20 gehalten, die mit den unten abstehenden Schenkeln 21 an einem Rahmen oder dgl. befestigt werden kann.

Fig. 3 zeigt im Querschnitt das Metallprofil 1 mit einem Sensorelement 16', das dem Lichtsender nach Fig. 2 gegenüberliegend angeordnet wird. Die Trägerplatte 15 für das Sensorelement 16' ist über einen Halter 22 zusätzlich gehalten, der in die im Querschnitt t-förmige Nut 17 eingesetzt ist. Mit 23 sind Kabel in einer der Nuten 13 bezeichnet. In die unten liegende flache Nut 14' ist bei dieser Ausführungsform eine lichtdurchlässige Platte 24 eines dem Sensorelement 16' vorgeschalteten optischen Systems eingesetzt.

Die Querschnittsform des Metallprofils 1 ist mit den von der Innen- und Außenseite eingebrachten Nuten so gestaltet, daß sich eine über den Querschnitt möglichst gleichbleibende Wandstärke ergibt, um ein Verziehen oder Wärmespannungen weitgehend zu vermeiden, wenn das Sensorgehäuse starker Wärmebeanspruchung ausgesetzt ist.

## Patentansprüche

1. Sensorgehäuse für einen gegenüber elektromagnetischer Strahlung empfindlichen optischen Sensor, insbesondere für Bahnlaufregeleinrichtungen, bei dem ein Lichtsender bzw. -empfänger (16) von einer Abschirmung aus leitendem Material umgeben ist, die aus einem im Querschnitt etwa U-förmigen Metallprofil (1) und einer in die Öffnung des Metallprofils eingesetzten lichtdurchlässigen Schicht (2) besteht, die zur leitenden Verbindung der Schenkelenden des Metallprofils (1) leitfähig ist oder mit einer leitfähigen Beschichtung (2a) versehen ist.

2. Sensorgehäuse nach Anspruch 1,
wobei die elektrisch leitfähige, lichtdurchlässige Schicht (2) oder elektrisch leitende Beschichtung (2a) an einer elektrisch leitfähigen Dichtung (3) anliegt, die in einer Nut (4) des Metallprofils (1) eingesetzt ist.

3. Sensorgehäuse nach Anspruch 1 oder 2,
wobei die elektrisch leitfähige, lichtdruchlässige Schicht als Glasplatte (2) ausgebildet ist, die mit einer elektrisch leitfähigen Beschichtung (2a) versehen ist.

4. Sensorgehäuse nach Anspruch 3,
wobei auf der der Dichtung (3) gegenüberliegenden Seite der Glasplatte (2) ein Klemmstreifen (7) zur Halterung der Glasplatte in einer Nut (6) des Metallprofils (1) vorgesehen ist.

5. Sensorgehäuse nach einem der Ansprüche 1 bis 4,
wobei das Metallprofil (1) auf dem Innen- und Außenumfang mit einer elektrisch isolierenden Eloxalschicht versehen ist, und die Nut (4) zur Aufnahme der elektrisch leitfähigen Dichtung (3) frei von einer solchen Eloxalschicht ist.

6. Sensorgehäuse nach einem der vorhergehenden Ansprüche,
bei dem der Außenumfang des Metallprofils (1) abgeflachte Abschnitte (11) zwischen abgerundeten Abschnitten (10) aufweist.

7. Sensorgehäuse nach Anspruch 6,
bei dem auf den abgeflachten Abschnitten (11) des Außenumfangs Nuten (12) ausgebildet sind.

8. Sensorgehäuse nach einem der vorhergehenden Ansprüche,
bei dem auf dem Innenumfang des Metallprofils (1) Nuten (13,14,17) zur Halterung von Leiterplatten bzw. einer Trägerplatte (15) für den Sensor (16) und dgl. ausgebildet sind.

9. Sensorgehäuse nach einem der vorhergehenden Ansprüche,
bei dem zumindest an den stirnseitigen Enden des Metallprofils (1) Bohrungen (18) für die Befestigung von stirnseitigen Abdeckplatten ausgebildet sind.

10. Sensorgehäuse nach einem der vorhergehenden Ansprüche,
bei dem das Metallprofil (1) aus einem Strangpreßprofil aus Aluminium besteht.

11. Verfahren zum Ausbilden eines elektrisch leitfähigen Bereichs auf einem mit einer elektrisch isolierenden Beschichtung versehenen Metallelement, insbesondere eines langgestreckten Metallprofils (1),
indem eine Nut (4) in dem Bereich ausgebildet wird, in dem eine elektrische Verbindung hergestellt werden soll,
in die Nut (4) ein Abdeckmaterial z.B. in Form einer Schnur eingebracht und danach das Metallelement mit einer elektrisch isolierenden Beschichtung z.B. durch Eloxieren versehen wird,
worauf nach dem Aufbringen der Beschichtung die Abdeckung der Nut (4) entfernt und ein elektrisch leitfähiges Material (3) eingesetzt wird, das über die Nut vorsteht.
